# EUROPÄISCHE PATENTSCHRIFT

(11) **EP 2 208 225 B1**
(45) Veröffentlichungstag und Bekanntmachung des Hinweises auf die Patenterteilung: **10.10.2018**
(21) Anmeldenummer: 07819865.2
(22) Anmeldetag: 13.11.2007
(51) Int. Cl.: H01L 23/40, H01L 25/11, H05K 7/14, H01L 25/07

(54) **LEISTUNGSHALBLEITERMODUL**
POWER SEMICONDUCTOR MODULE
MODULE SEMI-CONDUCTEUR DE PUISSANCE

(43) Veröffentlichungstag der Anmeldung: 21.07.2010
(73) Patentinhaber: Siemens Aktiengesellschaft, 80333 München (DE)
(72) Erfinder: DORN, Jörg, 96155 Buttenheim (DE); KÜBEL, Thomas, 91054 Erlangen (DE)
(86) Internationale Anmeldenummer: PCT/EP2007/009995
(87) Internationale Veröffentlichungsnummer: WO 2009/062534

(56) Entgegenhaltungen:
- EP-A- 0 033 399
- EP-A- 0 989 606
- EP-A- 1 172 850
- EP-A- 1 263 045
- WO-A-02/15268
- DE-A1- 4 407 810
- DE-A1-102004 018 477
- US-A- 4 878 106
- US-A- 4 963 976
- US-A1- 2003 198 022

## Beschreibung

Die Erfindung betrifft ein Leistungshalbleitermodul mit wenigstens zwei miteinander verschalteten Leistungshalbleitereinheiten, die jeweils ein Einheitengehäuse aufweisen, in dem ansteuerbare Leistungshalbleiter angeordnet sind, wobei jeder Leistungshalbleitereinheit eine Kühlplatte zugeordnet ist, mit der die ansteuerbaren Leistungshalbleiter Wärme leitend verbunden sind.

Die Erfindung betrifft ferner einen Stromrichterventilzweig aus einer Reihenschaltung solcher Leistungshalbleitermodule sowie einen Stromrichter aus solchen Stromrichterventilzweigen.

Eine solche Leistungshalbleitereinheit ist aus der DE 303 21 33 bereits bekannt. Die dort beschriebene Leistungshalbleitereinheit verfügt über druckkontaktierte Leistungshalbleiter, die zwischen zwei Elektroden verklemmt sind. Eine der Elektroden weist Anschlüsse für Kühlleitungen auf und dient somit gleichzeitig als Kühlplatte.

Aus der EP 1 263 045 A1 ist eine Leistungshalbleitereinheit bekannt, die ein Einheitengehäuse aufweist, in dem die IGBTs in Form von Chips angeordnet sind. Die IGBTs werden durch individuelle Druckfinger gegen eine Basiselektrode gepresst. Auf diese Art und Weise wird ein Druckkontakt bereitgestellt. Die Basisplatte ist mit einer Kühlplatte verbunden, wobei das Einheitengehäuse weiterhin formfeste Seitenwände aufweist, die sich von der Basisplatte zu einer Abdeckungselektrode erstrecken.

Aus der Offenlegungsschrift US 2003/0198022 A1 ist ein Modul für einen elektrischen Stromrichter bekannt. Dieses Modul weist eine Ober- und eine Unterseite aus einem gut wärmeleitenden Material sowie elektrisch isolierende Seitenwände auf. Im Inneren des Moduls sind mehrere Untereinheiten angeordnet, welche wärmeerzeugende elektrische Bauelemente enthalten.

Marktübliche Leistungshalbleitereinheiten sind in der Regel bereits mit einem Gehäuse und einer Kühlplatte ausgerüstet. Auch sind elektrische Verschaltungen solcher Einheiten bekannt. In der EP 0 845 809 A2 ist eine Leistungshalbleitereinheit beschrieben, die ein Gehäuse mit einer Kühlplatte aufweist. Das Gehäuse ist mit einem Schaumstoff befüllt, um im Explosionsfall Explosionskräfte aufzunehmen. Auf der Kühlplatte sind Leistungshalbleiterchips angeordnet, wobei Bonddrähte zum Miteinanderverbinden der Leistungshalbleiterchips vorgesehen sind. Der vorbekannten Leistungshalbleitereinheit haftet der Nachteil an, dass diese nur aufwändig mit einer weiteren Leistungshalbleitereinheit zu einem Leistungshalbleitermodul zusammengesetzt werden können, mit einer raumgreifenden Konstruktion im Gefolge. Insbesondere bei einem Einsatz im Bereich der Hochspannungs- und Starkstromtechnik kann es zum Wegschmelzen der Bonddrähte und zur Lichtbogenbildung kommen, wobei Explosionsgase entstehen. Aufgrund dieser unerwünschten Gefahrenquelle hat sich das vorbekannte Leistungshalbleitermodul im Bereich der Energieübertragung und -verteilung in der Praxis nicht durchsetzen können.

Der Erfindung liegt die Aufgabe zugrunde, ein Leistungshalbleitermodul der eingangs genannten Art bereitzustellen, das in seinem Aufbau kompakt und kostengünstig ist, wobei gleichzeitig ein Schutz im Explosionsfall bereitgestellt ist.

Die Erfindung löst diese Aufgabe durch ein Leistungshalbleitermodul nach dem Patentanspruch 1. Dieses Leistungshalbleitermodul weist ein Modulgehäuse auf, in dem die Leistungshalbleitereinheiten angeordnet sind, wobei die Kühlplatten eine Ober- und Unterseite des Modulgehäuses ausbilden.

Erfindungsgemäß ist ein Leistungshalbleitermodul mit wenigstens zwei Leistungshalbleitereinheiten bereitgestellt. Die Leistungshalbleiter jeder Leistungshalbleitereinheit sind mit einer Kühlplatte Wärme leitend verbunden, wie dies bereits aus dem Stand der Technik bekannt ist. Erfindungsgemäß sind beide Leistungshalbleitereinheiten in einem gemeinsamen Modulgehäuse angeordnet. Dabei bildet die Kühlplatte jeder Leistungshalbleitereinheit eine Begrenzungswandung des Modulgehäuses des Leistungshalbleitermoduls aus. Das erfindungsgemäße Leistungshalbleitermodul ist somit aus mehreren Leistungshalbleitereinheiten zusammengesetzt, wobei die Leistungshalbleitereinheiten beispielsweise ein eigenes Einheitengehäuse aufweisen, in dem zweckmäßig miteinander verbundene Leistungshalbleiterchips angeordnet sind. Das erfindungsgemäße Leistungshalbleitermodul ist beispielsweise einem Energiespeicher parallel geschaltet. Leistungshalbleitermodul und der Energiespeicher bilden dann gemeinsam ein Zweigmodul aus, wobei solche Zweigmodule unter Ausbildung eines Stromrichterventilzweiges in Reihe miteinander geschaltet sind. Solche Stromrichterventilzweige dienen wiederum als Phasenbaustein für einen so genannten Multilevel-Stromrichter, wie sie beispielsweise im Bereich der Energieübertragung und - verteilung zum Einsatz gelangen können. Darüber hinaus sind jedoch auch Anwendungen im Bereich der Antriebstechnik vorstellbar.

Dadurch, dass die Kühlplatten der Leistungshalbleitereinheiten gleichzeitig auch die oberen und unteren Gehäusewandungen für das Leistungshalbleitermodul darstellen, ist erfindungsgemäß ein kompaktes Bauteil bereitgestellt. Darüber hinaus dienen die in der Regel mechanisch stabilen Kühlplatten als Explosionsschutz.
Ansteuerbare Leistungshalbleiter sind beispielsweise abschaltbare Leistungshalbleiter, wie IGBTs, GTOs, IGCTs oder dergleichen, aber auch nicht abschaltbare Leistungshalbleiter, wie Thyristoren. Die Leistungshalbleitereinheit kann im Rahmen der Erfindung auch Leistungshalbleiter, wie Dioden, Freilaufdioden oder dergleichen, aufweisen, die nicht ansteuerbar sind.

Erfindungsgemäß verfügt das Modulgehäuse über Modulseitenwände, die sich zwischen den Kühlplatten erstrecken und die aus einem elektrisch nicht leitenden Isoliermaterial, wie beispielsweise Keramik, Kunststoff oder dergleichen, gefertigt sind. Abweichend von der Erfindung können auch die Modulseitenwände aus einem elektrisch leitenden Material bestehen.

Erfindungsgemäß sind Anschlussklemmen zum Anschließen der Leistungshalbleitereinheiten vorgesehen, wobei sich die Anschlussklemmen durch wenigstens eine der Modulseitenwände hindurch erstrecken. Auf diese Art und Weise ist ein konstruktiv einfacher Anschluss für das Leistungshalbleitermodul bereitgestellt.
Vorteilhafterweise sind die Leistungshalbleitereinheiten einander zugewandt. Dies bietet sowohl Vorteile hinsichtlich der Ausbreitung von Explosionsgasen oder Heißgasen, so dass die Explosionskräfte von den mechanisch festen Kühlplatten aufgenommen werden. Darüber hinaus ist auch eine einfache Verschienung mit den Anschlussklemmen ermöglicht. Zweckmäßigerweise ist das Modulgehäuse zur weiteren Dämpfung im Explosionsfall mit Füllstoffen, wie beispielsweise temperaturfesten Schaumstoffen, Kunststoffen oder dergleichen gefüllt.
Vorteilhafterweise sind die Leistungshalbleiter mittels Bonddrähte miteinander verbunden. Solche Leistungshalbleitereinheiten sind kostengünstig in großer Vielfalt am Markt erhältlich.
Vorteilhafterweise weist das Leistungshalbleitermodul wenigstens einen fest mit einer Kühlplatte verbundenen Haltekranz auf, der einen von der Kühlplatte aufragenden Seitenwandabschnitt ausbildet, welcher eine Leistungshalbleitereinheit zumindest teilweise umschließt. Durch den Haltekranz, der aus einem mechanisch festen Material und beispielsweise aus Metall oder Stahl besteht, ist ein zusätzlicher Explosionsschutz bereitgestellt.

Wie bereits weiter oben ausgeführt wurde, ist es zweckmäßig, dass ein solches Leistungshalbleitermodul einem Energiespeicher, wie beispielsweise einem Kondensator, unter Ausbildung eines Stromrichterventilzweigmoduls parallel geschaltet ist. Eine Reihenschaltung aus Stromrichterventilzweigmodulen bildet zweckmäßigerweise einen Stromrichterventilzweig aus, der beispielsweise über einen Wechselspannungsanschluss mit einer Phase eines Wechselspannungsnetzes und über einen Gleichspannungsanschluss an einen Gleichspannungszwischenkreis angeschlossen. Die Reihenschaltung erstreckt sich dann zwischen dem Wechselspannungsanschluss und dem Gleichspannungsanschluss.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen, und wobei
- Figur 1: eine perspektivische Darstellung eines Ausführungsbeispiels des erfindungsgemäßen Leistungshalbleitermoduls und
- Figur 2: eine quer geschnittene Seitenansicht des Leistungshalbleitermoduls gemäß Figur 1 zeigen.

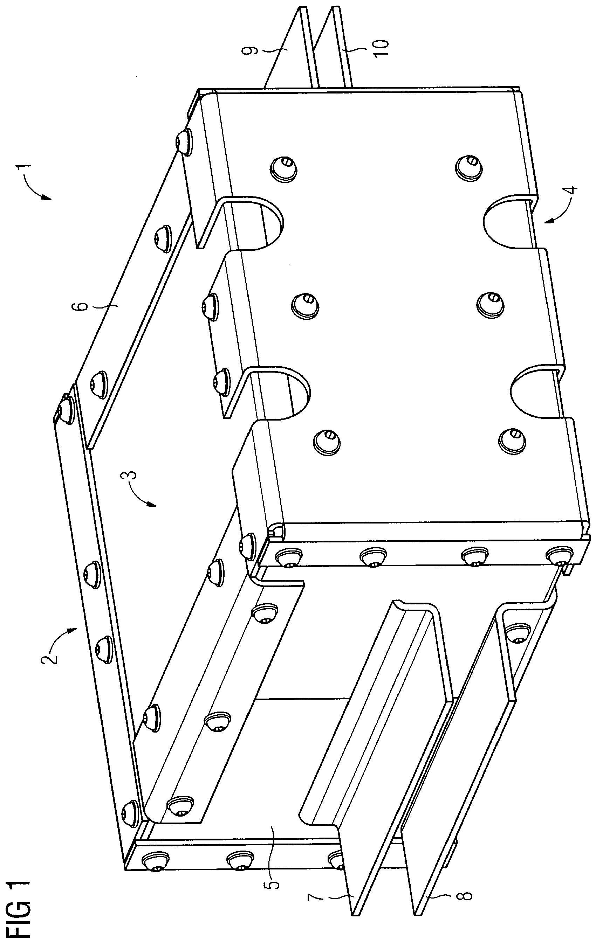

Figur 1 zeigt ein Ausführungsbeispiel des erfindungsgemäßen Leistungshalbleitermoduls 1 in einer perspektivischen Darstellung. Das gezeigte Leistungshalbleitermodul 1 verfügt über ein Modulgehäuse 2, das aus einer oberen Modulgehäusewandung 3, einer unteren Modulgehäusewandung 4 sowie Modulseitenwandungen 5 besteht. Zur mechanischen Verbindung der Modulgehäusewandungen 3, 4 und der Modulseitenwandungen sind Profilschienen 6 vorgesehen, die mit den jeweiligen Wandungen fest verschraubt sind. Zum elektrischen Anschluss des Leistungshalbleitermoduls 1 sind vordere Anschlussklemmen 7 und 8 sowie hintere Anschlussklemmen 9 und 10 vorgesehen. Die Anschlussklemmen 8 und 10 liegen auf einem Erdpotenzial, während die Anschlussklemmen 7 und 9 sich auf einem vergleichsweise höheren Potenzial, beispielsweise 1 Kilovolt, befinden.

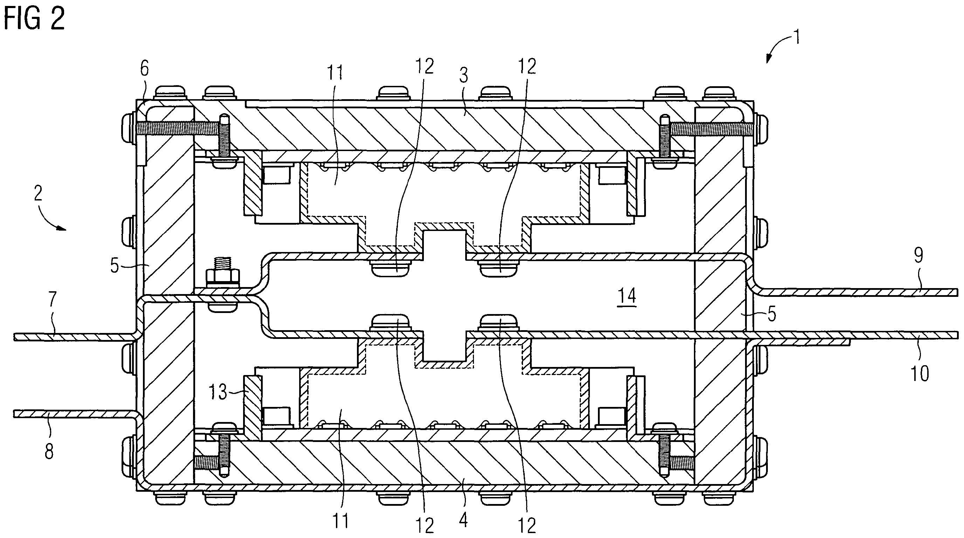

Figur 2 zeigt das Leistungshalbleitermodul 1 gemäß Figur 1 in einer quer geschnittenen Seitenansicht, in der die obere Modulgehäusewandung 3, die untere Modulgehäusewandung 4 sowie die Modulseitenwandungen 5 besser erkennbar sind. Insbesondere ist dargestellt, dass die obere Modulgehäusewandung 3 und untere Modulgehäusewandung 4 jeweils mit einer Leistungshalbleitereinheit 11 verbunden ist. Jede der Leistungshalbleitereinheiten 11 weist in ihrem Inneren schematisch dargestellte Leistungshalbleiter auf, die über Bonddrähte und sonstige Leiterbahnen miteinander verbunden sind. Zum Anschließen der Leistungshalbleitereinheiten 11 an die Anschlussklemmen 7, 8, 9, 10 dienen Anschlüsse 12. Die elektrische Verbindung der Anschlüsse 12 mit den schematisch in Figur 2 angedeuteten Leistungshalbleitern oder Leistungshalbleiterchips ist in Figur 2 aus Gründen der Übersichtlichkeit nicht dargestellt. Die nicht dargestellte Verbindung ist im Rahmen der Erfindung beliebig.

Die Leistungshalbleitereinheiten 11 sind identisch aufgebaut und sind einander zugewandt angeordnet, so dass deren Leistungshalbleiter oder Leistungshalbleiterchips Wärme leitend mit der oberen Modulgehäusewandung 3 beziehungsweise der unteren Modulgehäusewandung 4 verbunden sind. Die besagten Modulwandungen 3, 4 dienen gleichzeitig als Kühlplatten 3, 4 der Leistungshalbleiter der Leistungshalbleitereinheiten 11. Mit anderen Worten bilden die ohnehin zum Betrieb der Leistungshalbleitereinheiten 11 notwendigen Kühlplatten 3, 4 gleichzeitig die obere beziehungsweise untere Begrenzungswandung des Leistungshalbleitermoduls 1 aus. Auf diese Weise ist ein kostengünstiges Modulgehäuse 2 bereitgestellt. Dabei bildet das kompakte und kostengünstige Gehäuse 2 gleichzeitig einen Explosionsschutz aus.

Die Leistungshalbleitereinheiten 11 sind marktübliche Leistungshalbleitereinheiten, die ihrerseits in der Regel selbst über ein Einheitengehäuse verfügen, in dem wiederum Leistungshalbleiterchips als Leistungshalbleiter angeordnet sind. In dem gezeigten Ausführungsbeispiel der Erfindung sind die Leistungshalbleiterchips der Leistungshalbleitereinheiten 11 zumindest teilweise über Bonddrähte miteinander verbunden. Aufgrund dieser Verbindung der Leistungshalbleiterchips der Leistungshalbleitereinheiten 11 kann es insbesondere bei hohen Kurzschlussströmen zu einem Abschmelzen der Bonddrähte kommen mit einer Lichtbogenentwicklung im Gefolge. Der Lichtbogen setzt Explosionsgase frei, die aufgrund der einander zugewandten Anordnung der Leistungshalbleitereinheiten 11 im Wesentlichen gegen die stabile gegenüberliegende Kühlplatte 3, 4 als obere und untere Gehäusewandung gerichtet sind.

Jede Leistungshalbleitereinheit 11 ist von einem Haltekranz 13 umgeben, der mit seinem Flanschabschnitt auf der jeweiligen Kühlplatte 3, 4 fest verschraubt ist. Der von der jeweiligen Kühlplatte 3, 4 aufragende Seitenwandabschnitt des Haltekranzes 13 umschließt die jeweilige Leistungshalbleitereinheit 11 und bildet so einen zusätzlichen Explosionsschutz aus. Der Haltekranz 13 ist beispielsweise aus Stahl gefertigt.
Um die Explosionsfähigkeit des Leistungshalbleitermoduls noch weiter zu erhöhen, ist zwischen den Anschlüssen 12 der Leistungshalbleitereinheiten 11 ein Füllraum 14 vorgesehen, in dem ein temperaturfester Füllstoff angeordnet ist. Der Füllstoff ist beispielsweise ein nicht leitender temperaturfester Kunststoff. Im Explosionsfall verformt sich der Kunststoff und nimmt dabei freigesetzte Explosionsenergie auf.
Die Modulseitenwandungen 5 sind in den gezeigten Ausführungsbeispielen aus einem nicht leitenden Isolierstoff, beispielsweise einem mit Glasfasern verstärkten Kunststoff, hergestellt, wobei jedoch auch metallische, also elektrisch leitende Materialien, für die Modulseitenwandungen 5 ebenfalls in Frage kommen. Die Moduleitenwandungen 5 werden von der Anschlussklemme 7 beziehungsweise den Anschlussklemmen 9 und 10 durchgriffen, so dass ein einfacher Anschluss des Leistungshalbleitermoduls 1 von Außen ermöglicht ist. Im Falle von nicht erfindungsgemäßen elektrisch leitenden Modulseitenwandungen 5 sind die Anschlussklemmen 7, die auf einem Potential liegen, das von demjenigen der durchgriffenen Modulseitenwandungen 5 abweicht, mittels zweckmäßiger Isoliereinheiten gegenüber der besagten Modulseitenwandung 5 isoliert. Bei einer zweckmäßigen Weiterentwicklung sind marktübliche Durchführungen an der Modulseitenwand 5 befestigt, die einen isolierten Durchgriff der Anschlussklemmen 7 durch die jeweilige Modulseitenwandung 5 ermöglichen.
Das Leistungshalbleitermodul 1 ist vorteilhafterweise mit einem Kondensator oder einem anderen Energiespeicher parallel geschaltet, wobei die Parallelschaltung aus Leistungshalbleitermodul 1 und Energiespeicher ein Zweigmodul ausbilden. Eine Reihenschaltung aus Zweigmodulen bildet wiederum einen Stromrichterzweig aus, der Teil eines Multilevel-Stromrichters ist. Solche Multilevel-Stromrichter finden beispielsweise bei der Hochspannungsgleichstromübertragung Verwendung.

## Patentansprüche

1. Leistungshalbleitermodul (1) mit wenigstens zwei miteinander verschalteten Leistungshalbleitereinheiten (11), die jeweils ein Einheitengehäuse aufweisen, in dem ansteuerbare Leistungshalbleiter angeordnet sind, wobei jeder Leistungshalbleitereinheit (11) eine Kühlplatte (3,4) zugeordnet ist, mit der die ansteuerbaren Leistungshalbleiter Wärme leitend verbunden sind, wobei die Leistungshalbleiter Leistungshalbleiterchips sind, und
mit einem Modulgehäuse, in dem die Leistungshalbleitereinheiten angeordnet sind, wobei die Kühlplatten (3,4) eine Ober- und Unterseite des Modulgehäuses ausbilden, wobei das Modulgehäuse (2) über Seitenwandungen (5) verfügt, die sich zwischen den Kühlplatten (3,4) erstrecken und die aus einem Isoliermaterial bestehen,
wobei das Leistungshalbleitermodul über Anschlussklemmen (7,8,9,10) zum Anschließen der Leistungshalbleitereinheiten (11) verfügt wobei das Leistungshalbleitermodul **dadurch gekennzeichnet ist, dass** sich die Anschlussklemmen (7,8,9,10) durch die Seitenwandungen hindurch erstrecken.

2. Leistungshalbleitermodul (1) nach Anspruch 1,
**dadurch gekennzeichnet, dass** die Leistungshalbleitereinheiten (11) einander zugewandt sind.

3. Leistungshalbleitermodul nach einem der vorhergehenden Ansprüche,
**dadurch gekennzeichnet, dass** die Leistungshalbleiter mittels Bonddrähte miteinander verbunden sind.

4. Leistungshalbleitermodul nach einem der vorhergehenden Ansprüche,
**gekennzeichnet durch**
wenigstens einen fest mit einer Kühlplatte (3,4) verbundenen Haltekranz, welcher einen von der Kühlplatte aufragenden Seitenwandabschnitt aufweist, der eine Leistungshalbleitereinheit (11) zumindest teilweise umschließt.

5. Stromrichterventilzweig
**gekennzeichnet durch**
eine Reihenschaltung aus Leistungshalbleitermodulen (1) gemäß einem der vorhergehenden Ansprüche.

6. Stromrichter,
**gekennzeichnet durch**
eine Brückenschaltung aus Stromrichterventilzweigen gemäß Anspruch 5.

## Claims

1. Power semiconductor module (1) comprising at least two interconnected power semiconductor units (11) having in each case one unit housing in which drivable power semiconductors are arranged, each power semiconductor unit (11) being assigned a cooling plate (3, 4) to which the drivable power semiconductors are thermally conductively connected, the power semiconductors being power semiconductor chips, and
comprising a module housing, in which the power semiconductor units are arranged, the cooling plates (3, 4) forming a top side and underside of the module housing, the module housing (2) having sidewalls (5) which extend between the cooling plates (3, 4) and which are composed of an insulating material, the power semiconductor module having connection terminals (7, 8, 9, 10) for connecting the power semiconductor units (11), the power semiconductor module being **characterized in that** the connection terminals (7, 8, 9, 10) extend through the sidewalls.

2. Power semiconductor module (1) according to Claim 1,
**characterized in that**
the power semiconductor units (11) face one another.

3. Power semiconductor module according to either of the preceding claims,
**characterized in that**
Frei verwendbar
the power semiconductors are connected to one another by means of bonding wires.

4. Power semiconductor module according to any of the preceding claims,
**characterized by**
at least one holding ring which is fixedly connected to a cooling plate (3, 4) and which has a sidewall section projecting from the cooling plate, said sidewall section at least partly enclosing a power semiconductor unit (11).

5. Converter valve branch,
**characterized by**
a series circuit comprising power semiconductor modules (1) according to any of the preceding claims.

6. Converter,
**characterized by**
a bridge circuit comprising converter valve branches according to Claim 5.

## Revendications

1. Module (1) à semi-conducteur de puissance, comprenant au moins deux unités (11) à semi-conducteur de puissance connectées entre elles, qui ont chacune un boîtier d'unité dans lequel sont disposées des semi-conducteurs de puissance pouvant être mis à l'état passant, dans lequel, à chaque unité (11) à semi-conducteur de puissance est associée une plaque (3, 4) de refroidissement par laquelle les semi-conducteurs de puissance pouvant être mis à l'état passant sont reliés de manière à conduire la chaleur, les semi-conducteurs de puissance étant des puces à semi-conducteur de puissance et comprenant un boîtier de module, dans lequel les unités à semi-conducteur de puissance sont disposées, les plaques (3, 4) de refroidissement formant une face supérieure et une face inférieure du boîtier du module, le boîtier (2) du module disposant de parois (5) latérales, qui s'étendent entre les plaques (3, 4) de refroidissement et qui sont en un matériau isolant,
dans lequel le module à semi-conducteur de puissance dispose de bornes (7, 8, 9, 10) de connexion pour la connexion des unités (11) à semi-conducteur de puissance, le module à semi-conducteur de puissance étant **caractérisé en ce que** les bornes (7, 8, 9, 10) de connexion passent à travers les parois latérales.

2. Module (1) à semi-conducteur de puissance suivant la revendication 1,
**caractérisé en ce que**
les unités (11) à semi-conducteur de puissance sont tournées l'une vers l'autre.

3. Module (1) à semi-conducteur de puissance suivant l'une des revendications précédentes,
**caractérisé en ce que** les semi-conducteurs de puissance sont reliés entre eux au moyen de fils de liaison.

4. Module (1) à semi-conducteur de puissance suivant l'une des revendications précédentes,
**caractérisé par**
au moins une couronne de maintien, qui est reliée fixement à une plaque (3, 4) de refroidissement et qui a une partie de paroi de plaque, qui fait saillie de la plaque de refroidissement et qui entoure, au moins en partie, une unité (11) à semi-conducteur de puissance.

5. Branche de soupape de convertisseur,
**caractérisée par**
un montage série de module (1) à semi-conducteur de puissance suivant l'une des revendications précédentes.

6. Convertisseur
**caractérisé par**
un montage en pont de branches de soupape de convertisseur suivant la revendication 5.
